# EUROPEAN PATENT SPECIFICATION

(11) **EP 1 837 920 B1**
(45) Date of publication and mention of the grant of the patent: **29.02.2012**
(21) Application number: 05790663.8
(22) Date of filing: 07.10.2005
(51) Int. Cl.: H01L 31/0216, H01L 33/00, G02B 5/28

(54) **INFRARED-TRANSMITTING COVER**
INFRAROTSENDENDE ABDECKUNG
COUVERCLE TRANSMETTANT L'INFRAROUGE

(30) Priority: 12.11.2004 JP 2004328906; 14.04.2005 JP 2005117090
(43) Date of publication of application: 26.09.2007
(73) Proprietor: Tokai Optical Co., Ltd., Aichi 444-2192 (JP)
(72) Inventor: HASHIGUCHI, Takashi, c/o TOKAI OPTICAL CO., LTD., Okazaki-shi, Aichi 444-2192 (JP); MIYAGUCHI, Akira, c/o TOKAI OPTICAL CO., LTD., Okazaki-shi, Aichi 444-2192 (JP)
(74) Representative: Sherrard-Smith, Hugh
(86) International application number: PCT/JP2005/018649
(87) International publication number: WO 2006/051664

(56) References cited:
- WO-A1-94/09392
- JP-A- 63 098 601
- JP-A- 2000 314 807
- JP-A- 2000 352 612
- JP-A- 2001 110 577
- JP-A- 2003 004 942
- JP-A- 2004 053 719

## Description

### TECHNICAL FIELD

The present invention relates to infrared transparent covers, for example, a highly aesthetic infrared transparent cover attached to an infrared signal port for inputting and outputting infrared signals.

### BACKGROUND ART

Infrared signals are used for short-distance wireless data transmission (e.g., IrDA standard) between electronic devices. Infrared signals are also used for remote operations performed to turn on and off or control the volume of home electric appliances such as TVs and VCRs.

An infrared signal is received by an infrared light receiving element arranged in a receiver or a transmitter. Generally, the infrared light receiving element detects visible light in addition to infrared signals. In order to prevent ambient light such as visible light from entering the light receiving element, a black or dark colored resin window plate having near-infrared transparency is attached to an infrared signal port of a receiver or transmitter in the prior art. The black or dark colored resin window plate prevents external light, such as visible light, from causing erroneous functioning of the light receiving element. The black or dark colored resin window plate may also be attached to the infrared signal port of a transmitter. The black or dark colored resin window plate functions to hide the inside of a transmitter, a receiver, and a transceiver.

JP 2003004942 (A) discloses an IR sensor cover containing a transparent synthetic resin layer 1 which transmits IR rays, a mirror coat layer 2 produced by forming high refractive index substance layers and low refractive index layers on the surface of the resin layer 1, and a color material layer 3 formed on the mirror coat layer 2 and has >=70% transmittance for IR layers in the layered state of the above layers. The IR sensor unit is equipped with the above IE sensor cover.

A technique for attaching a transparent resin plate to a infrared signal port using a double-sided adhesive sheet that shields visible light and transmits infrared light is disclosed (see patent document 1).
Patent Document 1: Japanese Laid-Open Patent Publication No. 2002-226805

### DISCLOSURE OF THE INVENTION

The black or dark colored resin window plate of the prior art may in some cases not match with the outer appearance of electronic device or electric device. Thus, there is a limit to the freedom of designing when designing devices so that the black or dark colored resin window plate does not stand out.

The double-sided adhesive sheet disclosed in patent document 1 has a dark appearance coloring and absorbs visible light. Thus, the double-sided adhesive sheet has the same disadvantages as a black or dark colored resin window plate.

In principle, a resin window plate may be manufactured to have any appearance coloring by adding a coloring agent or by applying colored paint to a transparent resin plate. However, a resin window plate for an infrared signal port must have infrared transparency. It is difficult to manufacture a resin window plate having a random appearance coloring while maintaining infrared transparency and shielding visible light.

It is an object of the present invention to provide an infrared transparent cover for an electronic device having a random appearance coloring.

To achieve the above object, an infrared transparent cover for an infrared signal port of an electronic device, the infrared transparent cover comprising:
a base layer having infrared transparency, the outer surface or inner surface of the base layer being a frosted surface; and
an infrared transparent and visible light reflective dielectric multilayer film laminated on the outer surface or inner surface of the base layer, the dielectric multilayer film reflecting light having a color adjusted to the desired color, wherein the infrared transparent cover has an appearance coloring having pearl-like luster.

The present invention further provides an electronic device including a housing with an opening, an infrared detection element accommodated in the housing, and the infrared transparent cover attached to the housing and closing the opening.

The infrared transparent cover is manufactured through the step of forming an infrared transparent and visible light reflective dielectric multilayer film on one surface of a base layer, which has infrared transparency, under a low temperature by performing ion assist deposition, plasma CVD, or sputtering.

One aspect of the cover further includes a primer layer that has undergone a hard coating process and is laminated between the dielectric multilayer film and the base layer. The dielectric multilayer film serves as an outer surface of the cover.

In one aspect, the base layer includes a first surface on which the dielectric multilayer film is laminated and a second surface opposite the first surface. The cover further includes an antireflection film laminated on the second surface of the base layer, the dielectric multilayer film and the antireflection film respectively serving as an inner surface and an outer surface of the cover.

In one aspect, the base layer has two surfaces, and the dielectric multilayer film is laminated on the two surfaces of the base layer.

In one aspect, an interface between the base layer and the dielectric multilayer film is curved.

In one aspect, the interface between the base layer and the dielectric multilayer film is convex.

In one aspect, the cover is attached to an infrared signal port of an electronic device and the cover includes an outer surface exposed outside the electronic device and an inner surface arranged inside the electronic device. The base layer is colorless and transparent and includes a first surface close to the inner surface of the cover and a second surface close to the outer surface of the cover. The dielectric multilayer film is laminated on the first surface of the base layer. The cover further includes a black layer laminated on the dielectric multilayer film, having infrared transparency, and inhibiting transmission of visible light. A diffusion layer is laminated on the second surface of the base layer.

In one aspect, the base layer is colorless and transparent and includes a first surface close to the inner surface of the cover and a second surface close to the outer surface of the cover. The dielectric multilayer film is laminated on the first surface of the base layer. The cover further includes an information printed layer laminated on the dielectric multilayer film. A black layer is laminated on the information printed layer, has infrared transparency, and inhibits transmission of visible light. A diffusion layer laminated on the second surface of the base layer.

In one aspect, the information printed layer is a monolayer.

In one aspect, the base layer is colorless and transparent and includes a first surface close to the inner surface of the cover and a second surface close to the outer surface of the cover. The cover further includes an information printed layer laminated between the first surface of the base layer and the dielectric multilayer film. A black layer is laminated on the dielectric multilayer film, has infrared transparency, and inhibits transmission of visible light. A diffusion layer is laminated on the second surface of the base layer.

In one aspect, the information printed layer includes a plurality of layers.

In one aspect, the base layer is clear and colorless and includes a first surface close to the inner surface of the cover and a second surface close to the outer surface of the cover. The dielectric multilayer film is formed on the second surface of the base layer. The cover further includes a black layer laminated on the first surface of the base layer, having infrared transparency, and inhibiting transmission of visible light. A protective layer is laminated on the dielectric multilayer film.

### BRIEF DESCRIPTION OF THE DRAWINGS

Fig. 1 is a cross-sectional view of an infrared transparent cover according to the present invention;
Fig. 2 is a schematic diagram showing Fresnel reflection at a transparent base layer of the cover of Fig. 1;
Fig. 3 is a cross-sectional view of a portable information terminal to which the cover of Fig. 1 is attached;
Fig. 4(a) shows the spectrum for reflected light from the outer surface of the cover of Fig. 3, (b) shows the spectrum for reflected light from the inner surface of the cover of Fig. 3, (c) shows the spectrum for reflected light from an internal component of the portable information terminal of Fig. 3, (d) shows a synthesized spectrum of (b) and (c), and (e) shows the spectrum for light transmitted through
   the cover of Fig. 3;
Fig. 5 is a cross-sectional view of an infrared transparent cover according to a first embodiment of the present invention;
Fig. 6 shows a reflectance spectrum and transmission spectrum for a cover of example 1;
Fig. 7 is an xy chromaticity diagram;
Fig. 8 shows a reflectance spectrum and transmission spectrum for a cover of example 2;
Fig. 9 is a cross-sectional view of an infrared transparent cover according to a second embodiment of the present invention
Fig. 10 isacross-sectional view of an infrared transparent cover according to a third embodiment of the present invention;
Fig. 11 is a cross-sectional view of an infrared transparent cover according to a fourth embodiment of the present invention;
Fig. 12 is a cross-sectional view of an infrared transparent cover according to a fifth embodiment of the present invention;
Fig. 13 is a cross-sectional view of an infrared transparent cover according to a sixth embodiment of the present invention;
Fig. 14 shows a reflectance spectrum for a cover of example 3 that changes in accordance with the incident angle;
Fig. 15 is a cross-sectional view of an infrared transparent cover according to a seventh embodiment of the present invention;
Fig. 16 shows a reflectance spectrum and transmission spectrum for a dielectric multilayer film for the cover of Fig. 15;
Fig. 17 shows a transmission spectrum for a black layer of the cover of Fig. 15;
Fig. 18 is a plan view and a cross-sectional view showing an infrared transparent cover according to an eighth embodiment of the present invention;
Fig. 19(a) is a diagram showing reflected light from a cover of a comparison example, (b) is a front view of the cover of the comparison example;
Fig. 20 is a front view showing the cover of Fig. 18;
Fig. 21 is a plan view and a cross-sectional view showing an infrared transparent cover according to a ninth embodiment of the present invention;
Fig. 22 is a cross-sectional view of an infrared transparent cover according to a tenth embodiment of the present invention;
Fig. 23 is a cross-sectional view of an infrared transparent cover according to an eleventh embodiment of the present invention;
Fig. 24 is a perspective view showing an electronic device incorporating the infrared transparent cover of the present invention; and
Fig. 25 is a perspective view showing a modification of an infrared transparent cover.

### BEST MODE FOR CARRYING OUT THE INVENTION

An infrared transparent cover according to an embodiment of the present invention will now be described. In the description of each embodiment, like components will be denoted with the same reference numerals for the sake of brevity.

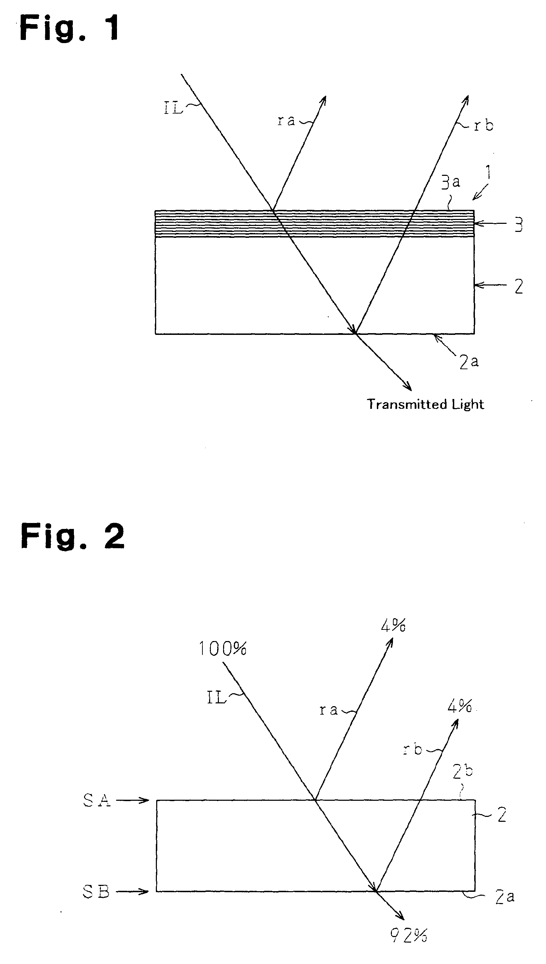

The basic structure of an infrared transparent cover 1 according to the present invention will first be described with reference to Fig. 1. The cover 1 is attached to a transmitter or a receiver, which transmit infrared signals in a unidirectional manner, and a transceiver, which transmits infrared signals in a bidirectional manner.

In the present specification, "outer surface" and "inner surface (rear surface)" of each layer respectively refer to the surfaces closer to the exterior and interior of an electronic device including an infrared signal port when the cover is attached to the electronic device. Specifically, the upper side as viewed in Fig. 1 is the outer surface of the cover 1 and layers, and the lower side is the inner surface of the cover 1 and the layers.

The cover 1 includes a case layer 2 having infrared transparency, and a dielectric multilayer film 3, formed on the cuter surface of the base layer 2 and having infrared transparency and visible light reflectivity. The cuter surface 3a of the dielectric multilayer film 3 is exposed to the outer side of the infrared signal port. The inner surface of the base layer 2 is arranged at the inner side of the infrared signal port.

If the base layer 2 having an index of refraction of 1.5 is arranged in air and the absorption of light by the base layer 2 can be ignored, about 4% of the incident light is reflected at each of interface SA between air and the outer surface 2b of the base layer 2 and interface SB between air and the inner surface 2a as Fresnel reflection, as shown in Fig. 2. Therefore, about 92% of the incident light is transmitted through the base layer 2.

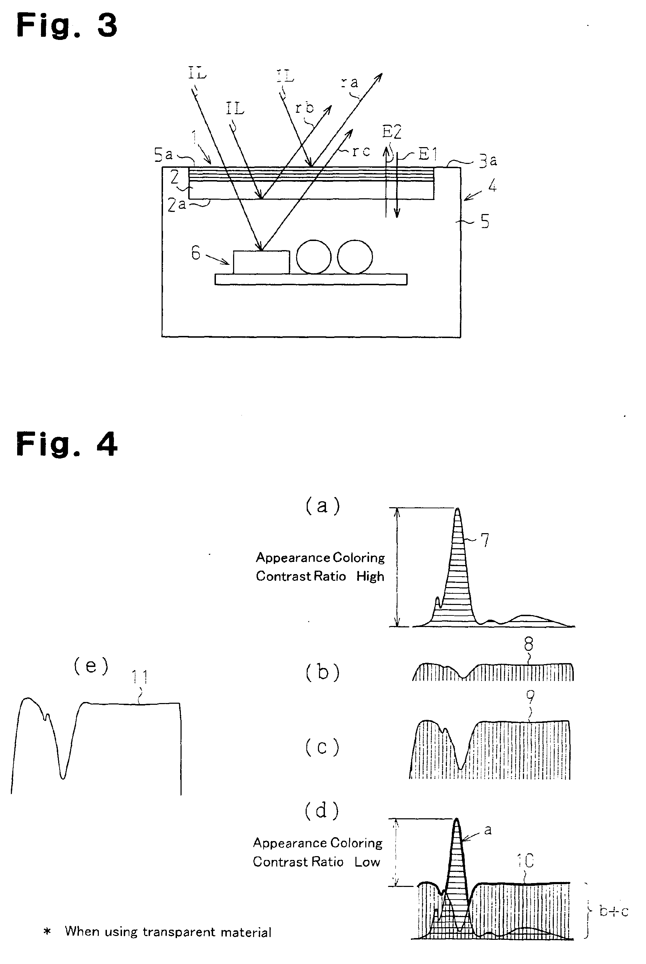

Fig. 3 shows a portable information terminal 4 to which the cover 1 is attached. The cover 1 is attached to an opening (infrared signal port) 5a formed in a housing 5 of the portable information terminal 4. The upper side of Fig. 3 is the outer surface of the cover 1 and the layers, and the lower side is the inner surface of the cover 1 and the layers. Some of the incident light IL is reflected at the outer surface of the cover 1 (reflected light ra). Some of the incident light IL is reflected at the inner surface of the cover 1 (reflected light rb). Some of the incident light IL is transmitted through the cover 1, and reflected by a component 6 such as a light receiving element arranged in the housing 5 (reflected light rc). The incident light IL is environmental light such as indoor lighting or sunlight.

In the incident light IL, the reflected light ra is the reflected light of the visible light in a specific wavelength band. In Fig. 4(a), curve 7 shows the spectral reflectance characteristic of the reflected light ra. The horizontal axis anc the vertical axis of Figs. 4(a) to (e) indicate wavelength and reflectivity, respectively.

In the incident light IL transmitted through the dielectric multilayer film 3, the reflected light rb is the light reflected at the interface between air and the inner surface 2a of the base layer 2 and emitted from the outer surface 3a of the cover 1. Curve 8 of Fig. 4(b) shows the spectral reflectance characteristic of the reflected light rb.

In the incident light IL transmitted through the dielectric multilayer film 3 and the base layer 2, the reflected light rc is the light reflected by the component 6 and emitted from the outer surface 3a of the cover 1. Curve 9 of Fig. 4(c) shows the spectral reflectance characteristic of the reflected light rc. The spectral reflectance characteristic of the surface of the component 6 is assumed to be flat and is ignored to simplify the description.

The cover 1 has a color (appearance coloring) that is in accordance with the synthesized spectrum of the reflected light ra, the reflected light rb, and the reflected light rc. The curve 10 of Fig. 4(d) shown by a thick line represents the synthesized spectrum of the reflected light ra, the reflected light rb, and the reflected light rc, and is the spectral reflectance characteristics of the entire cover 1. The cover 1 has an appearance coloring corresponding to the curve 10. As apparent from Fig. 4 (d), the contrast ratio of the appearance coloring of the cover 1 increases as the intensity (amount of light) of the reflected light rb and the reflected light rc decreases.

For example, in a cover 1 in which a dark color paint having infrared transparency and visible light absorption is applied to the inner surface 2a of the case layer 2 so that the inner surface 2a of the case 2 is colored black, light reaching the inner surface 2a is absorbed by the paint. In this case, the intensity of the reflected light rb and he reflected light rc from the inner surface 2a is substantially zero, and the appearance coloring of the cover 1 is more or less determined by the color of the reflected light ra at the outer surface 3a. For example, if the cover 1 has an appearance coloring with a large contrast ratio as shown by the curve 7 in Fig. 4(a) and reflected light ra is green, the cover 1 appears to have a green color with a large appearance coloring contrast ratio.

In the case of a cover in which black paint is removed from the inner surface 2a, reflected light is emitted having a synthesized spectrum of the reflected light rb, the reflected light rc, and the reflected light ra (curve 10 shown by thick lines in Fig. 4(d)). The reflected light appears to have a color close to white. Therefore, the cover 1 appears as a non-remarkable color having a small appearance coloring contrast ratio.

Curve 11 of Fig. 4(e) shows the spectrum distribution for light in incident light IL that is transmitted through the dielectric multilayer film 3 and the base layer 2 and emitted from the inner surface 2a.

An infrared signal E1 output from another electronic device is transmitted through the cover 1, as shown in Fig. 3.

An infrared signal E2 generated by the light emitting element such as the infrared light emitting diode accommodated in the housing 5 is transmitted through the cover, as shown in Fig. 3. The infrared signal E2 enters the inner surface 2a of the cover 1 and exists from the outer surface 3a of the cover

A state in which the incident light IL at the interface between air and the inner surface 2a of the base layer 2 is reflected is referred to as a state in which "rear surface reflection included". A state in which the incident light IL is not reflected at the interface or the reflected light rb is small such that it is negligible is referred to as a state in which "rear surface reflection ignored".

### (FirstEmbodiment)

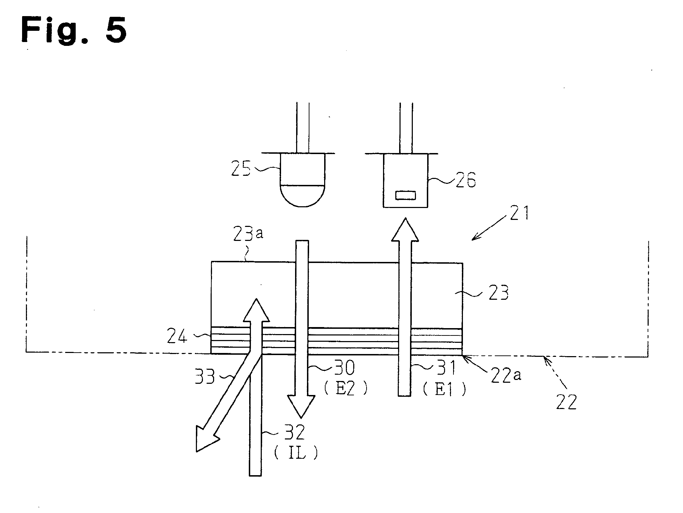

An infrared transparent cover 21 according to a first embodiment of the present invention will now be described with reference to Fig. 5.

A portable information terminal 22 serving as the electronic device includes a transceiver for transferring information or exchanging information in a cable-less manner with other electronic devices using infrared signals (e.g., infrared light having a wavelength in the vicinity of 850 nm). The infrared communication is performed in compliance with, for example, the IrDA standard. The cover 21 closes an opening (infrared signal port) 22a formed in the housing of the portable information terminal 22. The lower side as viewed in Fig. 5 is the outer surface of the cover 21 and the layers, and the upper side is the inner surface of the cover 21 and the layers.

The cover 21 includes a base layer 23 having infrared transparency and a dielectric multilayer film 24, which is formed on the outer surface of the base layer 23 with infrared transparency and visible light reflectivity.

The base layer 23 is made of resin material such as polycarbonate and acrylic resin. Resins other than polycarbonate and acrylic resin may be used as long as infrared light used for communication can be transmitted. The following shows examples of the base layer 23.
(1) a layer including flat and smooth cuter and inner surfaces and formed from a transparent and colorless material;
(2)a translucent layer formed from a transparent and colorless material and including a frosted surface (matted cuter surface or inner surface);
(3) an opalescent layer in which scattered substances (scattered particles) are dispersed;
(4) a dark colored layer having infrared transparency;
(5) an opaque transparent layer formed from a transparent and colorless material and being opaque by applying or printing dark color paint having infrared transparency on the inner surface.

The layer of (1) is used as the base layer 23 in the first embodiment.

The dielectric multilayer film 24 is formed by alternately laminating a thin film made of a material having a low refraction index and a film made of a material having a high refraction index. Examples of materials of the thin film include metal compounds of two or three types selected from metal oxide and metal fluoride. The dielectric multilayer film 24 has infrared transparency. The dielectric multilayer film 24 has spectral reflectance characteristic in the visible band that reflects the light of a desired color such as blue or yellow. In the present specification, infrared transparency refers to the property for transmitting infrared rays with high transmittance.

The transceiver of the portable information terminal 22 includes a light emitting element 25 such as an infrared light emittting diode for generating and outputting infrared signals, a light receiving element 26 for receiving infrared light, and an infrared transparent cover 21 attached to the infrared signal port. The light emitting element 25 and the light receiving element 26 are arranged near the rear surface 23a of the base layer 23 of the cover 21. Description and illustration of a light converging optical system arranged ahead of the light emitting and receiving elements or a complex element for emitting and receiving light with one element are omitted.

An infrared signal 30 emitted from the light emitting element 25 and transmitted through and out of the cover 21. The infrared signal 30 corresponds to the infrared signal E2 of Fig. 3. An external infrared signal 31 is transmitted through the cover 21 and received by the light receiving element 26. The infrared signal 31 corresponds to the infrared signal E1 of Fig. 3. Some of the visible light 32 entering the cover 32 is reflected at the dielectric multilayer film 24 and emitted outward as reflected light 33. The visible light 32 and the reflected light 33 respectively correspond to the incident light IL and the reflected light ra.

The remaining visible light 32 is transmitted through the dielectric multilayer film 24 and the base layer 23, with some of the light being reflected at the rear surface 23a of the base layer 23 and being emitted out of the cover 21 as reflected light rb shown in Fig. 3.

The first embodiment has the advantages described below.

The cover 21 includes the base layer 23, which has infrared transparency, and the dielectric multilayer film 24, which is laminated on the outer surface of the base layer 23 and has infrared transparency and visible light reflectivity. The dielectric multilayer film 24 reflects light having a color adjusted to the desired color while maintaining infrared transparency by appropriately selecting the spectral reflectance characteristic of the visible range of the dielectric multilayer film 24. This enables a cover 21 having a random appearance coloring while maintaining infrared transparency to be obtained. The cover 21 thus has a superior design, and the degree of freedom in design of the electronic device is improved.

The cover 21 attached to the housing of the electronic device has the desired aesthetic effect since the dielectric multilayer film 24 reflects light of a color adjusted to the desired color.

The dielectric multilayer film 24 has a spectral reflectance characteristic for reflecting light of desired color while maintaining infrared transparency. The cover 21 thus has an appearance coloring (color of reflected light) corresponding to the synthetic spectroscopic characteristic of the dielectric multilayer film 24 and the base layer 23 with respect to visible light.

For example, if the base layer 23 has a structure in a state in which "rear surface reflection ignored", and the dielectric multilayer film 24 has a spectral reflectance characteristic that most intensely reflects blue light, the cover 21 has an appearance coloring of a mixture of blue reflected light intensely reflected by the dielectric multilayer film 24 and weak reflected light of components other than blue (red and green) reflected by the rear surface 23a of the base layer 23.

The appearance coloring of a random color can be obtained while maintaining infrared transparency by appropriately changing the spectral reflectance characteristic of the visible band of the dielectric multilayer film 24. The cover 21 thus has a superior design, and the degree of freedom for designing the electronic device is improved.

Compared to when the base layer 23 is used alone, the transmittance of the near-infrared light is improved since the dielectric multilayer film 24, which is laminated on the base layer 23, is designed to reduce the Fresnel reflection of the base layer 23 with respect to the near-infrared light. The dielectric multilayer film 24 thus also has antireflection effect similar to that of a antireflection film with respect to the infrared signals 30 and 31. The reflection of the infrared signals 30 and 31 at the outer surface (interface SA of Fig. 2)of the base plate 23 is reduced by about 4% by the dielectric multilayer film 24. Therefore, loss of infrared signals 30, 31 due to reflection at the outer surface of the base plate 23 is reduced.

### (Example 1)

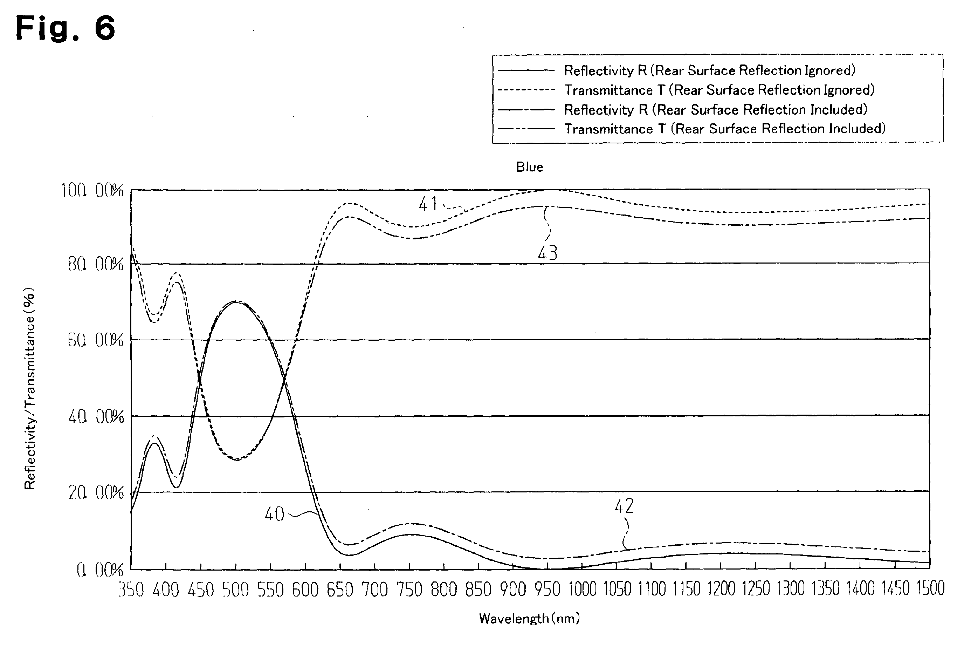

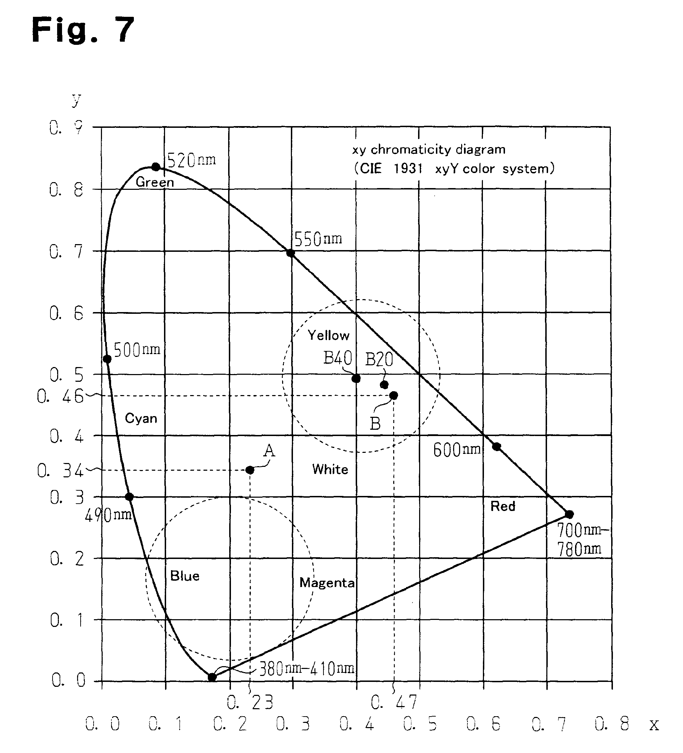

A cover of example 1 will now be described with reference to Figs. 6 and 7, and tables 1 and 2.

The cover of example 1 has the same layer structure as the cover 21 shown in Fig. 5 and includes a base layer 23 made of acrylic resin and a dielectric multilayer film 24 that transmits infrared light and reflect blue light. The dielectric multilayer film 24 is configured from eight layers of thin films in which film substance (ZrOₙ) of a material having high refraction index and film substance (SiO₂) of a material having low refraction index are laminated in an alternate manner. The dielectric multilayer film 24 reflects light having a median wavelength λc. The median wavelength λc is related to the color of the reflected light, that is, the color of the cover. The eight layers terming the dielectric multilayer film 24 of example 1 are designed to reflect light having the median wavelength λc of 495 nm, that is, blue light.

**Table 1**

| Example 1: blue color reflection, median wavelength λc: 495 nm, number of dielectric multilayer films: 3 | | | |
|---|---|---|---|
| Air Side | Material | Physical Film Thickness (nm) | Optical Film Thickness n·d |
| Thin Film Layer | | | |
| 1 | SiO₂ | 78.61 | 1 |
| 2 | ZrO₂ | 57.37 | 1 |
| 3 | SiO₂ | 78.61 | 1 |
| 4 | ZrO₂ | 57.37 | 1 |
| 5 | SiO₂ | 79.4 | 1 |
| 6 | ZrO₂ | 54.38 | 1 |
| 7 | SiO₂ | 159.15 | 1 |
| 8 | ZrO₂ | 20 | 1 |
| Base Layer 23 Side | | | |

Fig. 6 shows the spectral reflectance characteristic and the spectral transmission characteristic of the dielectric multilayer film 24 in example 1. In Fig. 6, curve 40 shows the spectral reflectance characteristic (reflectivity R) in a state in which "rear surface reflection ignored." Curve 41 shows the spectral transmission characteristic (transmittance T) in a state in which "rear surface reflection ignored." In Fig. 6, curve 42 shows the spectral reflectance characteristic (reflectivity R) in a state in which "rear surface reflection included." Curve 43 shows the spectral transmission characteristic (transmittance T) in a state in which "rear surface reflection included."

The curves 40 and 42 show that the reflectivity of the infrared light in the vicinity of 900 µm is very low and that the transmittance of the infrared light is very high in both states in which "rear surface reflection ignored" and "rear surface reflection included." The reflectivity of light (blue light) in the wavelength band in the vicinity of 500 nm is about 70% and high. The transmittance of the light in the wavelength band is about 30% for both states in which "rear surface reflection ignored" and "rear surface reflection included." The reflectivity can be adjusted as required.

The color of the reflected light of the dielectric multilayer film 24 of example 1 will now be described. The color of the reflected light of the dielectric multilayer film 24 is apparent from the chromaticity coordinate value (x, y) of table 2 and the xy chromaticity diagram shown in Fig. 7. Fig. 7 is a chromaticity diagram of the xyY color system. In table 2, Y represents the brightness of the reflected light.

**Table 2 Chromaticity of Example 1**

| Chromaticity Coordinate Value | | |
|---|---|---|
| X | Y | Y |
| 0.23 | 0.34 | 49.16 |

The chromaticity specified by the chromaticity coordinate value (x=0.23, y=0.34) of table 2 is the chromaticity (blue) at point A in Fig. 7.

Example 1 has the following advantages.

The dielectric multilayer film 24 has a function for transmitting light of infrared rays (infrared light) in the vicinity of 900 nm at a high transmittance close to 100%, and a function for reflecting the light (blue light) in the vicinity of 495 nm at a reflectivity of about 70% with respect to visible light. The cover of example 1 including the dielectric multilayer film 24 thus has a blue appearance coloring (reflected light) while maintaining infrared transparency.

### (Example 2)

The cover or example 2 has the same Layer structure as the cover 21 shown in Fig. 5 and includes a base layer 23 made of acrylic resin and a dielectric multilayer film 24 that reflects yellow light. The dielectric multilayer film 24 includes seven layers of thin films in which a film substance (ZrO₂) for a material having high refraction index and a film substance (SiO₂) for a material having low refraction index are laminated in an alternate manner. The median wavelength λc of the dielectric multilayer film 24 is the wavelength (600 nm) of yellow reflected light.

**Table 3**

| Example 2: yellow color reflection, median wavelength λc: 600 nm, number of dielectric multilayer films: 7 | | | |
|---|---|---|---|
| Air Side | Material | Physical Film Thickness (nm) | Optical Film Thickness n·d |
| Thin Film Layer | | | |
| 1 | SiO₂ | 45.21 | 0.44 |
| 2 | ZrO₂ | 74.94 | 1 |
| 3 | SiO₂ | 101.91 | 1 |
| 4 | ZrO₂ | 74.94 | 1 |
| 5 | SiO₂ | 102.96 | 1 |
| 6 | ZrOₙ | 84.39 | 1.184 |
| 7 | siO₂ | 192.06 | 1.864 |
| Base Layer 23 Side | | | |

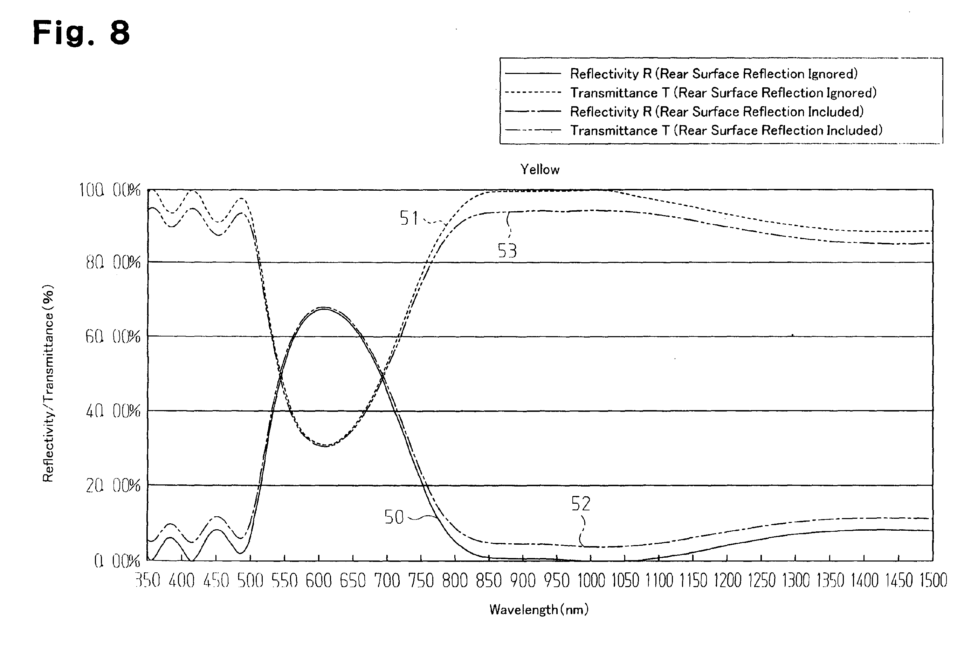

Fig. 8 shows the Spectral reflectance characteristic and the spectral transmission characteristic of the dielectric multilayer film 24 in example 2. In Fig. 8, curve 50 shows the spectral reflectance characteristic reflectivity R) for a state in which "rear surface reflection ignored." Curve 51 shows the spectral transmission characteristic (transmittance T) for a state in which "rear surface reflection ignored." Curve 52 shows the spectral reflectance characteristic (reflectivity R) for a state in which "rear surface reflection included." Curve 53 shows the spectral transmission characteristic (transmittance T) for a statue is which "rear surface reflection included."

Curves 50 and 52 of Fig. 8 show that the reflectivity of the infrared light in the vicinity of 900 nm is very low and that the transmittance of the infrared light is very high for both states in which "rear surface reflection ignored" and "rear surface reflection included." Curves 50 and 52 also show that the reflectivity of the light (yellow light) of wavelength band in the vicinity of 600 nm is high or about 70%, and the transmittance of the light of the wavelength band is about 30% for both states in which "rear surface reflection ignored" and "rear surface reflection included."

Table 4 shows the chromaticity coordinate value of the reflected light of the dielectric multilayer film 24 in example 2. The color of the reflected light of the dielectric multilayer film 24 is apparent from the chromaticity coordinate value (x, y) and the xy chromaticity diagram shown in Fig. 7.

**Table 4 Chromaticity of Example 2**

| Chromaticity Coordinate Value | | |
|---|---|---|
| X | Y | Y |
| 0.4 7 | 0.46 | 48.62 |

The chromaticity specified by the chromaticity coordinate value (x=0.47, y=0.46) of table 4 is the chromaticity (yellow) at point B in Fig. 7.

Example 2 has the advantages described below.

The dielectric multilayer film 24 functions to transmit the light of infrared rays (infrared light) in the vicinity of 900 nm at a high transmission close to 100%, and a function of reflecting the light (yellow light) in the vicinity of 600 nm at a reflectivity of about 70% with respect to visible light. The cover of example 2 including the dielectric multilayer film 24 thus has a yellow appearance coloring while maintaining infrared transparency.

### (Second Embodiment)

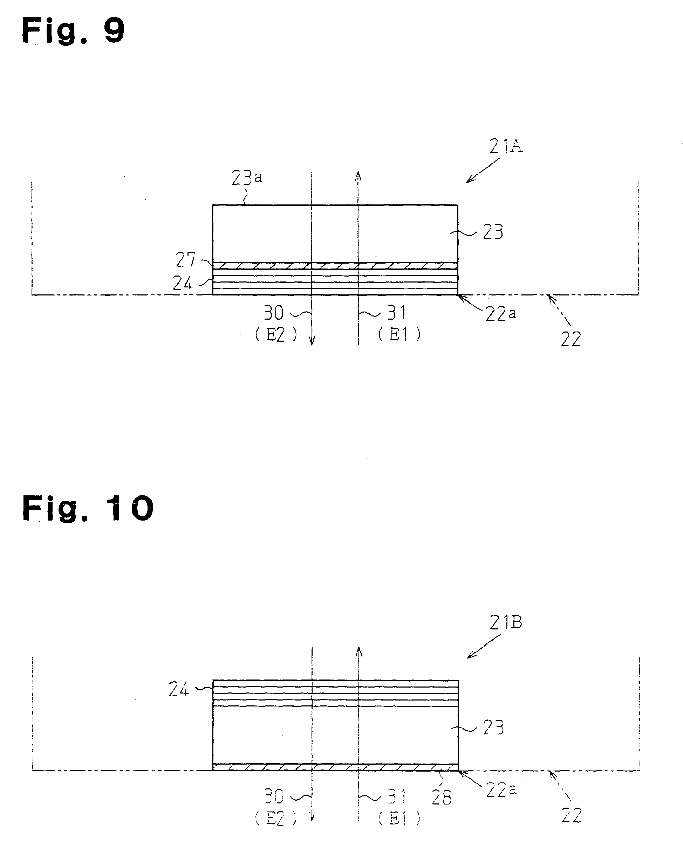

An infrared transparent cover 21A according to a second embodiment of the present invention will now be described with reference to Fig. 9. The lower side as viewed in Fig. 9 is the outer surface of the cover 21A and the layers, and the upper side is the inner surface of the cover 21A and the layers.

The cover 21A differs from the cover 21 of the first embodiment in that a primer layer 27 that undergoes a hard coating process is arranged between the dielectric multilayer film 24 and the base layer 23.

Generally, acrylic resin such as polymethyl methacrylate (PMMA) is less likely to adhere to the dielectric film. The primer layer 27 that undergoes a hard coating process coats the base layer 23, and the dielectric multilayer film 24 is formed on the primer layer 27. The dielectric multilayer film 24 is prevented from being peeled from the base layer 23, the surface Hardness of the base layer 23 is increased, and the durability of the cover 21A is improved.

### (Third Embodiment)

An infrared transparent cover 21B according to a third embodiment of the present invention will now be described with reference to Fig, 10. The lower side as viewed in Fig. 10 is the outer surface of the cover 21B and the layers, and the upper side is the inner surface of the cover 21B and the layers

The cover 21B of the second embodiment includes the dielectric multilayer film 24, which is laminated on the inner surface of the base layer 23, and an antireflection film 28, which is laminated on the outer surface of the base layer 23.

The reflection of infrared light is reduced by about 4% at each of the two interfaces of the base layer 23 (total of about 8%) by the antireflection film 28 and the dielectric multilayer film 24. This reduces loss of infrared signals.

Since the antireflection film 28 reduces the reflection at the outer surface of the base layer 23, the contrast ratio of the visible reflected light of the dielectric multilayer film 24 contained in the reflected light ra shown in Fig. 3 is improved, and the light that is reflected has a further emphasized color. The cover 21B thus has a clearer appearance coloring. This improves the aesthetic appeal of the infrared signal port.

The dielectric multilayer film 24 is arranged on the inner surface of the base layer 23. Thus, the dielectric multilayer film 24 is less likely to be damaged. The cover 21B thus increases the aesthetic appeal of the infrared signal port over a long period of time.

### (Fourth Embodiment)

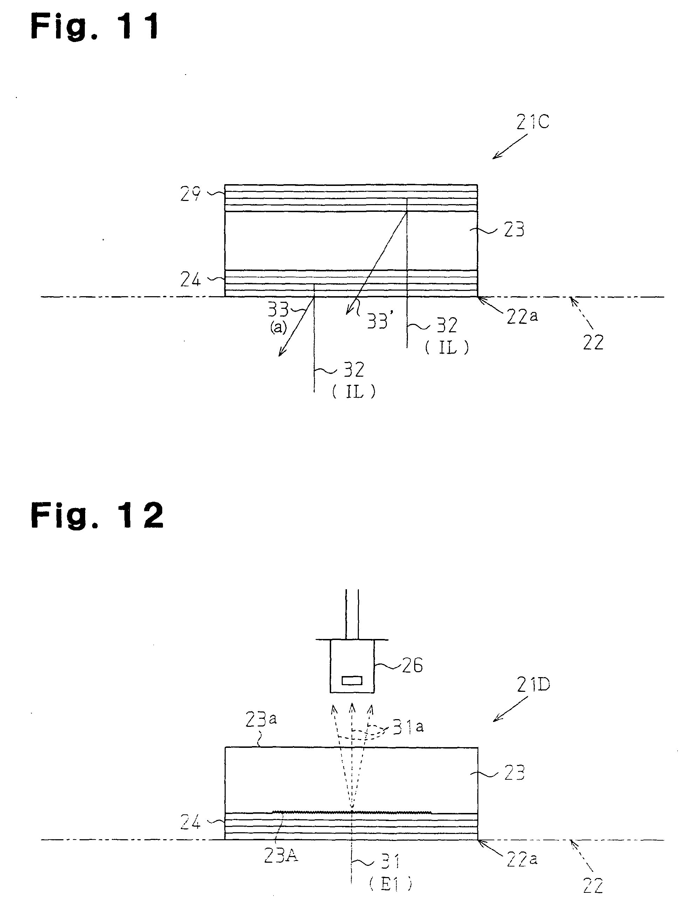

An infrared transparent cover 21C according to a fourth embodiment of the present invention will now be described with reference to Fig. 11. The lower side as viewed in Fig. 11 is the cuter surface of the cover 21C and the layers, and the upper side is the inner surface of the cover 21C and the layers.

The cover 21C includes the dielectric multilayer film 24, which is laminated on the cutter surface of the base layer 23, and a dielectric multilayer film 29, which is laminated on the inner surface of the base layer 23. The cover 21C has an appearance coloring, which is a combined color or the reflected light 33 reflected at the dielectric multilayer film 24 and the color of a reflected light 33' reflected at the interface of the dielectric multilayer film 29 and the base layer 23.

The dielectric multilayer film 24 on the outer side may be designed to reflect the light 33 of a blue color while maintaining the infrared transparency, and the dielectric multilayer film 29 on the inner side may be designed to reflect the light 33' of a yellow color while maintaining the infrared transparency. In this case, the cover 21C has an appearance coloring of a mixture of blue and yellow and thus has a superior design and high aesthetic effect.

The base layer that transmits infrared light and shields visible light may be formed from a resin material obtained by kneading materials for shielding the light rays of a specific wavelength band, such as an absorbent, paint, or ink. Alternatively, a dielectric multilayer film that reflects the light rays of the entire visible wavelength band and unnecessary infrared wavelength bands at a certain short wavelength side may be formed on the inner surface of the base layer to shield such light rays. In this case, the light rays of an easily and accurately adjusted wavelength can be shielded with high accuracy compared to when the materials for shielding the light rays are kneaded.

### (Fifth Embodiment)

An infrared signal transparent cover 21D according to Fifth embodiment of the present invention will now be described with reference to Fig. 12. The lower side as viewed in Fig. 12 is the cuter surface of the cover 21D and the layers, and the upper side is the inner surface of the cover 21D and the layers.

A frosted glass surface (frosted region) 23A for scattering light rays is formed on part of or on the entire outer surface of the transparent base layer 23, which is made of acrylic resin, in the cover 21D. The remaining structure is the same as the first embodiment.

The frosted region 23A scatters the infrared light to lower the directivity of the infrared light, but can be used in a limited manner when the light receiving element 26 is arranged close to the base layer 23 on the inner side of the cover 21D.

The frosted region 23A generates scattered light of a whitish translucent color (opalescent color) when observed in the visible light region. The cover 21D has an appearance coloring having pearl-like luster of a mixture of the color of the reflected light of the dielectric multilayer film 24 and the color of the whitish translucent scattered light of the frosted region 23A.

The base layer 23 has a translucent outer appearance like the ground glass since the outer surface of the transparent base layer 23 is frosted. Therefore, the inside of the electronic device is not visible when the cover 21D is attached to the electronic device.

The cover 21D may be used attached to the infrared light receiving port of the home electric appliances such as a TV or a VCR. In this case, the infrared signal (infrared light of remote controller wavelength band), which is for performing remote controlling to turn on and off or control the volume of a home electric appliance, is received by the home electric appliance through the cover 21D.

### (Sixth Embodiment)

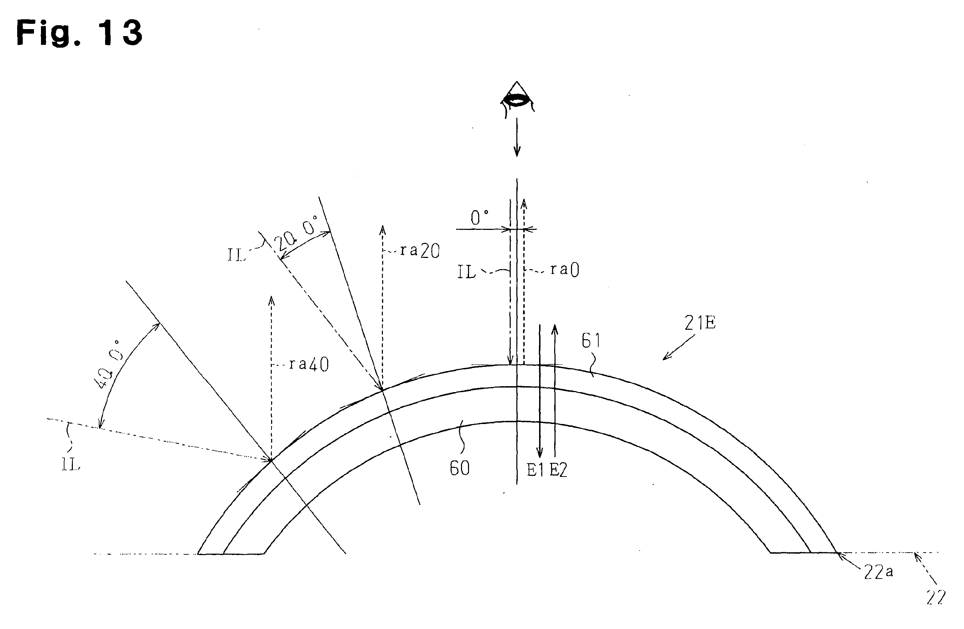

An infrared transparent cover 21E according to a sixth embodiment of the present invention will now be described with reference to Fig. 13. The upper side as viewed in Fig. 13 is the outer surface of the cover 21E and the layers, and the lower side is the inner surface of the cover 21E and each layer.

The cover 21E includes a base layer 60 having a curved outer surface, and a dielectric multilayer film 61 laminated on the outer surface of the base layer 60. An example of the base layer 60 is a semi-cylinder or dome having a convex outer surface.

The sixth embodiment has the advantages described below.

The appearance coloring of the cover 21E differs depending on the viewing angle. If the angle of incident light IL with respect to the normal line of the cover 21E is 0°, the color of reflected light ra0 (0 degree reflection) reflected at the outer surface of the dielectric multilayer film 61, the color of reflected light ra20 (20 degrees reflection) when the incident angle is 20°, and the color of reflected light ra4C (40 degrees reflection) when the incident angle is 40° differ from each other. The cover 21E thus appears to have an iridescent color, which results in a luxurious appearance.

### (Example 3)

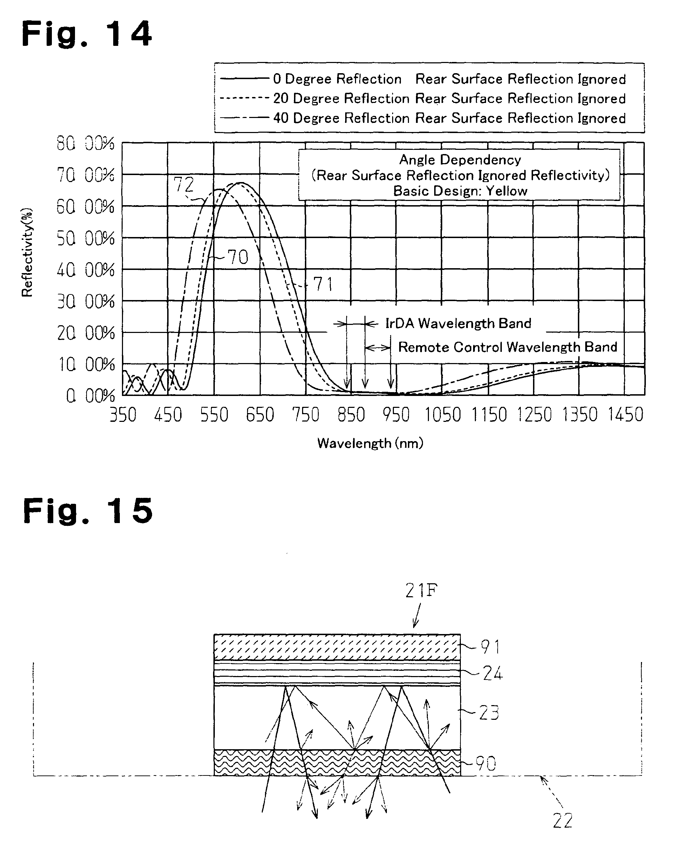

Example 3 of the cover 21E of the sixth embodiment will be described with reference to Fig. 14, Fig. 7, and table 5, and table 6.

As shown in table 3, the cover 21E of example 3 has the same structure as the cover of example 2 shown in table 2 except that the base layer has a curved surface. The cover 21E of example 3 thus has infrared transparency and reflects yellow light.

**Table 5**

| Example 3: yellow color reflection, median wavelength λc: 600 nm, number of dielectric multilayer films: 7, curved base layer used | | | |
|---|---|---|---|
| Air Side | Material | Physical Film Thickness (nm) | Optical Film Thickness n·d |
| Thin Film Layer | | | |
| 1 | SiO₂ | 45.21 | 0.444 |
| 2 | ZrO₂ | 74.94 | 1 |
| 3 | SiO₂ | 101.91 | 1 |
| 4 | ZrO₂ | 74.94 | 1 |
| 5 | SiO₂ | 102.96 | 1 |
| 6 | ZrO₂ | 84.39 | 1.184 |
| 7 | SiO₂ | 192.06 | 1.864 |
| Base Layer 23 Side | | | |

Fig. 14 shows the spectral reflectance characteristic of the cover 21E of example 3. Curve 70 shows the spectral reflectance spectrum of the reflected light ra0 with the 0 degree reflection. Curve 71 shows the spectral reflectance spectrum of the reflected light ra20 with the 20 degree reflection. Curve 72 shows the spectral reflectance spectrum of the reflected light ra40 with the 40 degree reflection. All of these cases are for states in which "no rear surface reflection ignored."

As apparent from curves 70, 71, and 72 of Fig. 14, the reflectivity with respect to infrared light near 900 nm (infrared light of wavelength band for IrDA and remote controller) is very low, and absorption of the dielectric multilayer film is negligibly small, and thus the transmittance of the relevant infrared light is very high.

As apparent from curves 70, 71, and 72 of Fig. 14, the wavelength of the visible light having the maximum reflectivity changes, that is, the color of the reflected light differs in accordance with the incident angle.

Table 6 shows the chromaticity coordinate value representing the colors of the reflected lights ra0, ra20, ra40 of example 3. All of these cases are for states in which "rear surface reflection ignored." The chromaticity represented by the chromaticity coordinate value, that is, the color of the reflected light of the dielectric multilayer film 24 is obtained from the chromaticity coordinate value (x, y) and the xy chromaticity diagram shown in Fig. 7.

**Table 6**

| Angle of Incident Light | Chromaticity Coordinate Value | | |
|---|---|---|---|
| | x | y | Y |
| 0 Degree Reflection Rear Surface Reflection Ignored | 0.47 | 0.46 | 48.62 |
| 20 Degrees Reflection Rear Surface Reflection Ignored | 0.46 | 0.48 | 52.94 |
| 40 Degree Reflection Rear Surface Reflection Ignored | 0.4 | 0.49 | 58.19 |

The chromaticity specified by the chromaticity coordinate value (x=0.47, y=0.46) of the reflected light ra0 is chromaticity yellow) of point B in Fig. 7. The chromaticity specified by the chromaticity coordinate value (x=0.46, y=0.48) of the reflected light ra20 is the chromaticity (yellow) at point B20 in Fig. 3. The chromaticity specified by the chromaticity coordinate value (x=0.4, y=0.49) of the reflected light ra40 is the chromaticity (yellow) at point B40 in Fig. 7.

Example 3 has the advantages described below.

The cover 21E has an appearance coloring that differs depending on the viewing angle while maintaining the transmittance of infrared light in the vicinity of 900 nm close to 100%. Specifically, the color of the reflected light continuously changes from yellow to greenish yellow as the angle of incident light IL changes from 0 degree to 40 degrees. The cover 21 thus has a luxurious appearance and superior design due to the changing appearance coloring, and the degree of freedom in designing the electronic device is improved.

The optical property of the cover 21E changes in accordance with the incident angle even in the wavelength band of the infrared signal. However, the change in optical property in the infrared region is small, and thus the transmittance with respect to infrared signals E1, E2 substantially does not decrease, as shown in Fig. 14.

### (Seventh Embodiment)

An infrared transparent cover 21F according two a seventh embodiment of the present invention will now be described with reference to Fig. 15. The lower side as viewed in Fig. 15 is the outer surface of the cover 21F and the layers, and the upper side is the inner surface of the cover 21F and the layers.

The cover 21F induces the transparent base layer 23 having infrared transparency and visible light transparency, the dielectric multilayer film 24 formed on the inner surface of the base layer 23, a black layer 91 formed on the inner surface of the dielectric multilayer film 24 to transmit infrared light and inhibit the transmission of the visible light, and a diffusion layer 90 formed on the outer surface of the transparent base layer 23.

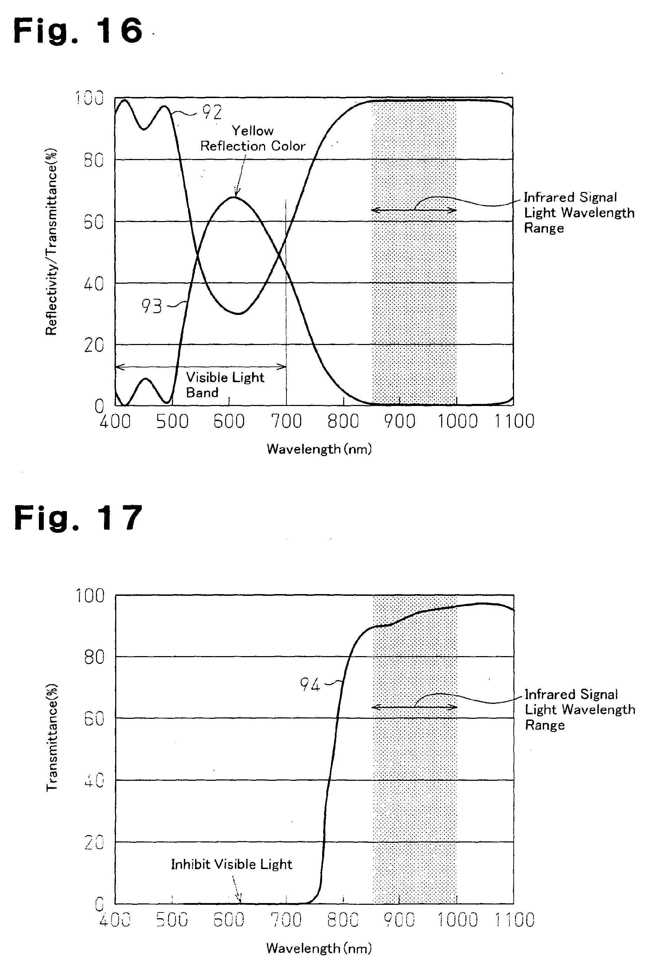

Curve 92 of Fig. 16 shows the spectral transmission characteristic of the dielectric multilayer film 24. The dielectric multilayer film 24 has high transmittance with respect to blue, red and infrared light. The cover 21F including the dielectric multilayer film 24 reflects yellow light (see curve 93).

Curve 94 of Fig. 17 shows the spectral transmission characteristic of the black layer 91. One wavelength band of the infrared signal is shown in Figs. 16 and 17.

The diffusion layer 90 prevents the layer dielectric multilayer 24 from being observed black or dark. In a cover that does not have the diffusion layer 90, when a dark scenery or person facing the outer surface of the cover is reflected in the dielectric multilayer film 24, the color (color of reflected light) of the dielectric multilayer film 24 would become difficult to see and the cover would appear blackish to the observer. That is, the incident light observed by the observer is reduced. In the cover 21F of the seventh embodiment, the diffusion layer 90 suppresses such reflection, averages external incident light, and scatters the reflected light to and from the dielectric multilayer film 24. Thus, the visible light reflected at the dielectric multilayer film 24 towards the observer relatively increases. Therefore, the reflected light of the dielectric multilayer 24 becomes easier seen outside of the cover 21F, and the cover 21F has a brilliant appearance coloring (yellow) in the present embodiment.

The diffusion layer 90 may be a layer roughened by directly performing physical or chemical process on the outer surface of the transparent base layer 23. Alternatively, the diffusion layer 90 may be printed or applied and laminated on the outer surface of the base layer 23.

If the transparent base layer 23 is made of resin such as acrylic resin having low adhesiveness relative to the dielectric multilayer film 24, a primer layer that undergoes a hard coating process may be laminated on the inner surface of the base layer 23.

The seventh embodiment has the advantages described below.

The diffusion layer 90 functions to average the incident light. Additionally, the diffusion layer 90 functions to scatter the reflected light of the dielectric multilayer film 24. The reflected light of the dielectric multilayer film 24 is thus easily observed from outside the cover 21F, and the black layer 91 is less likely to be observed. The cover 21F thus does not appear blackish, but has a brilliant appearance coloring (yellow reflected light) in correspondence with the color of the reflected light of the dielectric multilayer film 24.

### (Eighth Embodiment)

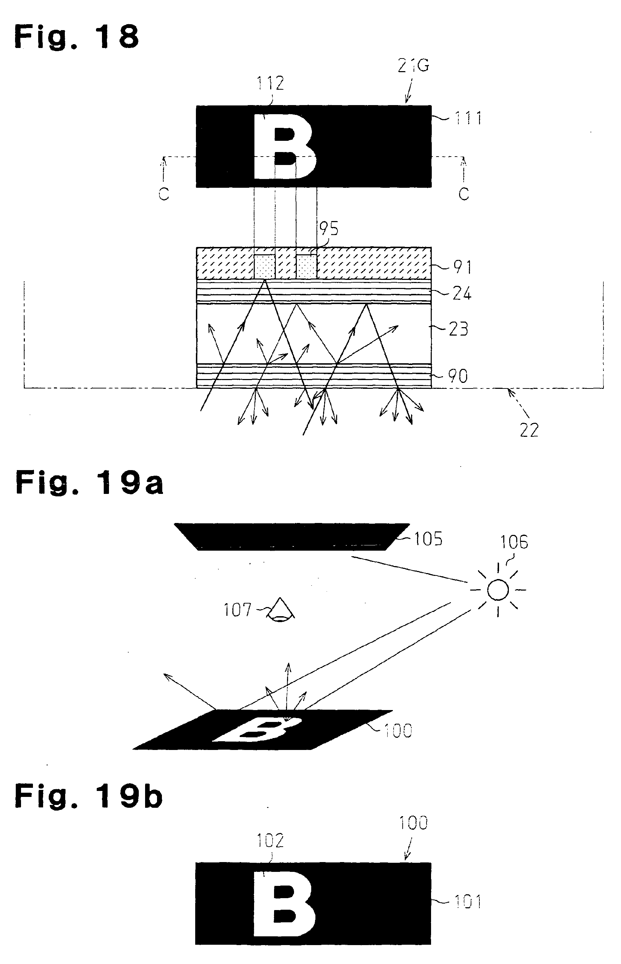

An infrared transparent cover 21G according to an eighth embodiment of the present invention will now be described with reference to Fig. 18. Fig. 18 is a plan view showing the cover 21G and a cross-sectional view taken along line C-C of the cover 21G.

The lower side as viewed in Fig. 18 is the outer surface of the cover 21G and the layers, and the upper side is the inner surface of the cover 21G and the layers. The cover 21G includes the transparent base layer 23 having infrared transparency and visible light transparency, the dielectric multilayer film 24 formed on the inner surface of the base layer 23, the black layer 91 formed on the inner surface of the dielectric multilayer film 24 and transmitting infrared light but inhibiting the transmission of visible light, the diffusion layer 90 formed on the outer surface of the transparent base layer 23, and an information printed layer 95 formed between the dielectric multilayer film 24 and the black layer 91. Information such as characters, images, and patterns are printed on the information printed layer 95. The remaining structure is the same as the cover 21F of Fig. 15.

An example of the information printed layer 95 is a monolayer directly printed on the inner surface of the dielectric multilayer film 24. In Fig. 18, a character 112 of B is printed in white ink. The character 112 is actually printed on the inner surface of the dielectric multilayer film 24 with a reverse plate (mirror image). Images and patterns may also be printed.

If the transparent base layer 23 is made of resin such as acrylic resin having low adhesiveness relative to the dielectric multilayer film 24, a primer layer that undergoes a hard coating process may be laminated on the inner surface of the base layer 23.

The eighth embodiment has the advantages described below.

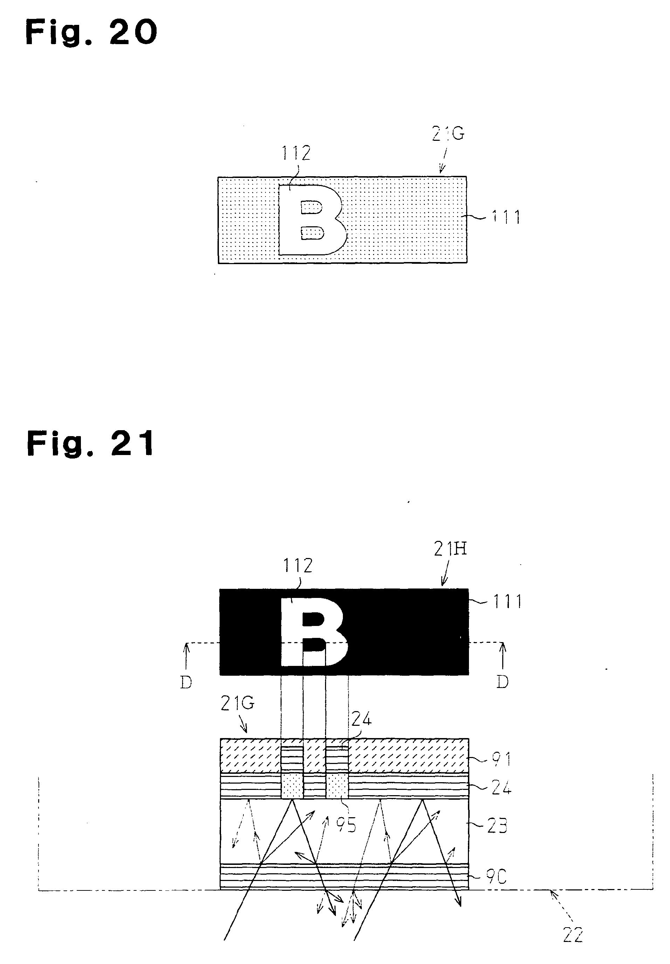

The transparency of the dielectric multilayer film 24 with respect to visible light is adjusted so that information such as characters, images, and patterns formed on the information print layer 95 is visible from the cuter side of the cover 21G. The layer structure of the dielectric multilayer film 24 is adjusted so that the dielectric multilayer film 24 selectively allows the transmission of the visible light of a specific wavelength band. Referring to Fig. 20, due to the reflected light of the dielectric multilayer film 24, an observer of the cover 21G can see a yellow background region 111 and the character 112 of a white B in the background region 111. The cover 21 thus has superior design, and the degree of freedom in designing the electronic device is improved.

The diffusion layer 90 functions to average the incident light. The diffusion layer 90 also functions to scatter the reflected light of the dielectric multilayer film 24. This relatively increases the visible light reflected by the dielectric multilayer film 24 towards the observer. A brilliant appearance coloring (reflected color of yellow) corresponding to the color of the reflected light of the dielectric multilayer film 24 is observed from the outer side of the cover 21G, and the black layer 91 is less likely to be observed. As shown in Fig. 19a, when a cover 100 of a comparison example that does not have a diffusion layer is arranged in front of a dark colored object 105, a light source 106 is arranged diagonally in front of the cover 100, and the observer 107 is in front of the cover 100, the black layer 91 can be observed by the observer through the semi-transmissive dielectric multilayer film 24 without being obstructed by the reflected light of the dielectric multilayer film 24. The light rays scattered at the information printed layer 95 are also observed by the observer 107. Therefore, a white character 102 is seen in the dark background region 101 and the reflected color of the dielectric multilayer film 24 is barely seen by the observer of the cover 100 of the comparison example, as shown in Fig. 19b.

The haze amount (haze value) of the diffusion layer 90 is determined to an extend in which the lowering of visibility of the character 112 is not affected. The cover 21G thus displays information such as letters, images, and patterns in the background region of a brilliant color (reflected color of yellow in the present example).

The information printed layer 95 is a monolayer printed with information such as letters, images, and patterns of bright color. The information printed layer 95 is easily added. Thus, the cover 21G displaying information such as the character 112 is easily manufactured.

The cover 21G having an outer appearance including the background region 111 of a brilliant color and the character 112 has superior design, and the degree of freedom in design of the electronic device is improved.

### (Ninth Embodiment)

An infrared transparent cover 21H according to a ninth embodiment of the present invention will now be described with reference to Fig. 21. Fig. 21 is a plan view showing the cover 21H and a cross-sectional view of the cover 21H taken along line D-D.

The difference between the cover 21H and the cover 21G shown in Fig. 18 is in that the dielectric multilayer film 24 and the information printed layer 95 are exchanged.

The lower side or Fig. 21 is the outer surface of the cover 21H and each layer, and the upper side is the inner surface of the cover 21H and each layer. The cover 21H includes the transparent base layer 23, the information printed layer 95 formed on the inner surface of the transparent base layer 23, the dielectric multilayer film 24 laminated on the transparent base layer 23 and the information printed layer 95, the black layer 91 laminated on the dielectric multilayer film 24, and the diffusion layer 90 formed on the outer surface of the base layer 23. An example of the information printed layer 95 is a monolayer containing information such as characters, images, and patterns directly printed on the inner surface of the base layer 23.

The ninth embodiment has the advantages described below.

The information formed on the information printed layer 95 can be directly seen through the diffusion layer 90 and the transparent base layer 23. The observer of the cover 21H sees the character 112 of B in the bright yellow background region 111, as shown in Fig. 20. Therefore, the cover 21H has superior design, and the degree of freedom in design of the electronic device is improved.

The haze amount (haze value) of the diffusion layer 90 is determined such that the lowering in visibility of the letter 112 is not affected. Therefore, the cover 21H can display information such as a character, image, and pattern in the background region of brilliant color (reflected color of yellow in the present example).

The information printed layer 95 is a monolayer on which information such as a character, image, and pattern of bright color is printed. The information printed layer 95 is easily added. The color of the information printed layer 95 can be easily changed, and a plurality of colors can be easily used. The cover 21H displaying information such as the character 112 is thus easily manufactured.

The cover 21H of which cuter appearance includes the background region 111 of brilliant color and the letter 112 has excellent design, and the degree of freedom in design of the electronic device is improved.

### (Tenth Embodiment)

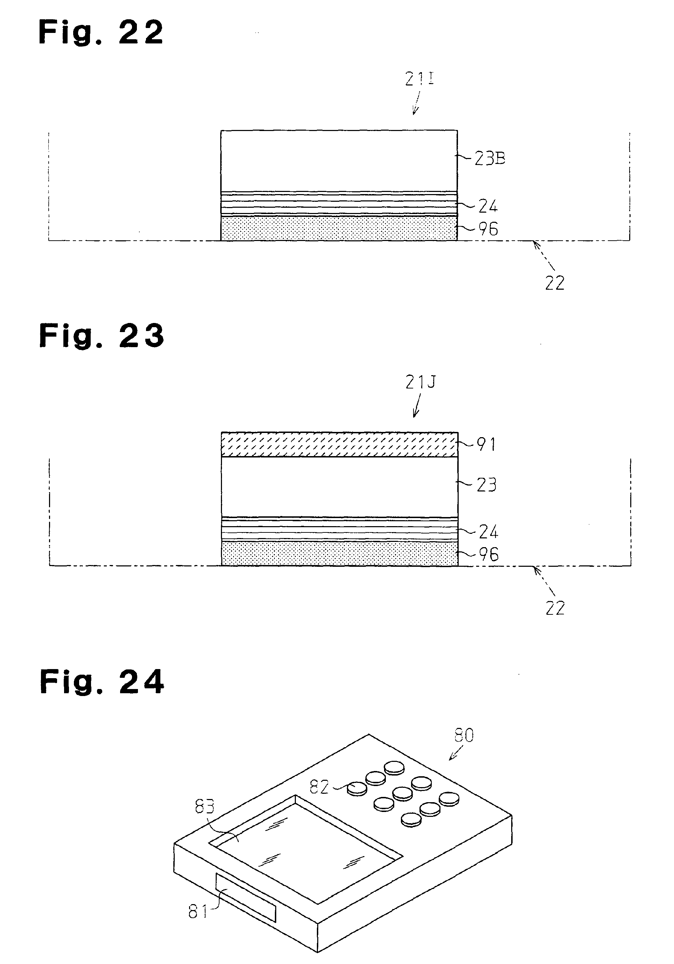

An infrared transparent cover 21I according to a tenth embodiment of the present invention will now be described with reference tc Fig. 10. The lower side as viewed in Fig. 22 is the outer surface of the cover 21I and each layer, and the upper side is the inner surface of the cover 21I and each layer.

The cover 21I includes a base layer 23B of a dark color and having infrared transparency, the dielectric multilayer film 24 formed on the outer surface of the base layer 23B, and a protective layer 96 formed on the outer surface of the dielectric multilayer film 24.

The protective layer 96 may be hardened by a hard coating and may include a substance having antifouling and sliding properties such as a hydrophobic coating or the like formed through a spraying method, immersion method, sputtering method, vacuum deposition method, or the like. The protective layer 96 improves the sliding and antifouling properties of the outer surface of the cover 21I. A protective layer 96 formed by vacuum depositing an organe-silicon water repellent agent is extremely thin and has a uniform thickness and is thus preferable.

If the infrared transparent dark colored base layer 23B is made of resin such as acrylic resin having low adhesiveness relative to the dielectric multilayer film 24, a primer layer that undergoes a hard coating process may be laminated on the outer surface of the base layer 233.

The protective layer 96 prevents deterioration of the dielectric multilayer film 24 that would be caused by scratches, oil, and the like. This enhances the durability of the cover 21I.

A thin protective layer 96 having a thickness of 10 nm or less may be formed by performing a vacuum deposition method. Thus, the protective layer 96 does not cause interference color and the influence on the spectral characteristics on the dielectric multilayer film 24 is extremely small.

### (Eleventh Embodiment)

An infrared transparent cover 21J according to an eleventh embodiment of the present invention will now be described with reference to Fig. 23. The lower side as viewed in Fig. 23 is the outer surface of the cover 21J and the layers, and the upper side is the inner surface of the cover 21J and the layers.

The difference between the cover 21J and the cover 21I of Fig. 22 is in that the transparent base layer 23 is used instead of the infrared transparent dark colored base layer 23B, and that the black layer 91, which transmits infrared light and inhibits the transmission of visible light, is formed on the inner surface of the transparent base layer 23. The remaining structure and advantages are the same as the cover 21I of Fig. 22.

### (Method for Manufacturing Infrared Transparent Cover)

The method for manufacturing an infrared transparent cover according to the present invention will now be described. An example of a method for manufacturing the cover 21 of the first embodiment will now be discussed. This manufacturing method is applicable when manufacturing covers other than the cover 21 of the first embodiment. The manufacturing method is suitable for manufacturing a cover including the base layer formed from a material having a relatively low softening point.

The method for manufacturing the infrared transparent cover includes the following steps.

The dielectric multilayer film 24, which has infrared transparency and visible light reflectivity, is formed on the outer surface of the base layer 23, which has infrared transparency, with a low temperature film formation technique. The low temperature film formation technique is a technique for forming a thin film while maintaining the base layer at a temperature lower than or equal to the softening point. Examples of low temperature film formation technique include IAD (Ion Assist Deposition), plasma CVD, and sputtering formation (sputtering).

The embodiment of the method for manufacturing the infrared transparent cover has the advantages described below.

Resin material such as polycarbonate and acrylic resin used for the base layer 23 has a low softening point temperature. In the conventional vacuum deposition method, the base layer 23 is normally heated to between 200°C and 300°C to adhere the dielectric multilayer film 24 to the base layer 23. It is thus difficult to form the dielectric multilayer film 24 on the base layer 23 made of a material having a low softening point such as resin through the conventional vacuum deposition method. The dielectric multilayer film 24 is formed en the outer surface of the base layer 23 through a low temperature deposition technique such as IAC (Ion Assist Deposition), plasma CVD, sputtering formation (sputtering; and the like in the present embodiment, and thus the dielectric multilayer film 24 having the desired spectral characteristics is formed on the base layer 23 made of a resin material having a low softening point temperature.

### (Electronic Device incorporating Infrared Transparent Cover)

One embodiment of an electronic device incorporating an infrared transparent cover according to the present invention will now be described with reference to Fig. 24.

Fig. 24 shows a portable information terminal 80 serving as the electronic device. The portable information terminal 80 includes a housing to which the infrared transparent cover 81 is attached, operation keys 82, and a display unit 83. The cover 81 has the structure described in the above embodiments and examples.

The electronic device incorporating the embodiment of the infrared transparent cover has the advantages described below.

The portable information terminal 80 includes the infrared transparent cover 81 that enables a random appearance coloring to be obtained. The portable information terminal 80 having superior design and an improved degree of freedom in design is obtained by changing the appearance coloring of the cover 81 in accordance with the color of the housing of the portable information terminal 80 or by changing the color of the housing in accordance with the appearance coloring of the cover 81.

The above embodiments may be modified as below.

The base layers 22, 60 may be one of (1) to (5) described above. The cover may have an appearance coloring corresponding to the selection of the base layer. For example, the transparent base layer 23 of the first to fourth embodiments and the transparent base layer 60 of the sixth embodiment may be changed to an opalescent base layer. In this case, the appearance coloring in which the color (opalescent) of the reflected light from the opalescent base layer is added to the color (reflected light) of the reflected light by the dielectric multilayer film 24 (dielectric multilayer film 61 in the sixth embodiment) is obtained. This obtains a texture having pearl-like luster and a luxurious appearance.

The base layer 23 of the first to the fourth embodiments and the base layer 60 of the sixth embodiment may be changed to the (4) dark colored base layer or (5) opaque base layer. In this case, the color (reflected color) of the reflected light by the dielectric multilayer film 24 (dielectric multilayer film 61 in the sixth embodiment) becomes clearer, and the effect of hiding the interior of the infrared transparent cover in a state attached to the electronic device is also obtained.

In the fifth embodiment shown in Fig. 12, the inner surface of the base layer 23 may be frosted instead of frosted finishing the outer surface of the transparent base layer 23. The effects of the fifth embodiment are still obtained in this case.

A resin material such as polycarbonate and acrylic resin having low softening point temperature (material of low softening point) is used for the base layer 23, and the dielectric multilayer film 24 is formed on the base layer 23 through the low temperature film formation technique in the method for manufacturing the infrared transparent cover. However, if the case layer is made of a material having high softening point such as glass, the dielectric multilayer film is formed on the base layer through methods other than the low temperature film formation technique such as the conventional vacuum deposition method.

The dielectric multilayer film 24 of example1 shown in table 1 is a lamination of eight thin films configured to obtain an appearance coloring of blue. The dielectric multilayer film 24 may be formed by laminating eight thin films so as to obtain an appearance coloring other than blue, for example, an appearance coloring of yellow. The number of thin films is not limited to eight.

The dielectric multilayer film 24 of examples 2 and 3 shown in tables and 5 are laminations including seven thin films configured to obtain an appearance coloring of yellow. The dielectric multilayer film 24 may be formed by laminating seven thin films so as to obtain an appearance coloring other than yellow, for example, an appearance coloring of blue. The number of thin films is not limited to seven.

The information printed layer 95 may be formed from a plurality of layers on which characters, images, and patterns are printed in the eighth embodiment shown in Fig. 18 and the ninth embodiment shown in Fig. 21.

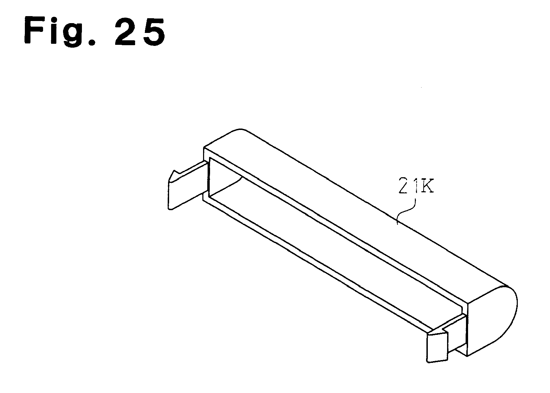

The cover of each embodiment is not limited to a flat plate or a curved plate, and various shapes may be adopted. The shape of the cover is changed to adapt to the outer appearance of the electronic device. The cover 21K shown in Fig. 25 is a three dimensional cap having side walls. The cover 21K may include attachment hooks for engagement with the electronic device.

Those skilled in the art would appropriately change the type of the deposition substances forming the dielectric multilayer film such as ZrO₂, SiO₂, the film thickness of each layer and the like in accordance with the appearance coloring of the desired cover. The cover may have an appearance coloring of blue, light blue, green, yellow, pink, red, silver or the like in accordance with the dielectric multilayer film.

The infrared transparent cover of the present invention is not limited to a portable information terminal 80 and is applicable to various electronic devices that incorporate a transparent cover such as a desktop computer, a laptop computer, and a digital camera.

The cover of the present invention may be used for a monitoring camera that uses an image sensor such as a CCD or a CMOS. The monitoring camera detects near-infrared rays. The monitoring camera is desirably arranged in a store unnoticeably. The monitoring camera may be used in a state accommodated in a housing having a photographing window to which the cover of the present invention is attached.

Calculators, wrist watches, and power generators are known as electronic devices including solar batteries. Such electronic devices include a light receiving surface having a relatively wide light receiving area. The light of main electrical power generating wavelength received by the light receiving surface enters the solar battery arranged inside the housing of the electronic device. If the main electrical power generating wavelength is in the infrared range, the cover of the present invention may be attached to the light receiving surface to improve the aesthetic appeal of the light receiving surface.

## Claims

1. An infrared transparent cover (1) for an infrared signal port of an electronic device, the infrared transparent cover comprising ;
a base layer (2) having infrared transparency, **characterised by** the outer surface (3a) or inner surface (2a) of the base layer being a frosted surface; and
an infrared transparent and visible light reflective dielectric multilayer film (3) laminated on the outer surface (3a) or inner surface (2a) of the base layer, the dielectric multilayer film (3) reflecting light having a color adjusted to the desired color, wherein the infrared transparent cover has an appearance coloring having pearl-like luster.

2. The infrared transparent cover according to claim 1, further comprising:
a primer layer that has undergone a hard coating process and is laminated between the dielectric multilayer film and the base layer, wherein the dielectric multilayer film serves as an outer surface of the cover.

3. The infrared transparent cover according to claim 1, wherein the base layer includes a first surface on which the dielectric multilayer film is laminated and a second surface opposite the first surface, the cover further comprising:
an antireflection film laminated on the second surface of the base layer, the dielectric multilayer film and the antireflection film respectively serving as an inner surface and an outer surface of the cover.

4. The infrared transparent cover according to claim 1, wherein:
the base layer has two surfaces; and
the dielectric multilayer film is laminated on the two surfaces of the base layer.

5. The infrared transparent cover according to claim 1, wherein an interface between the base layer and the dielectric multilayer film is curved.

6. The infrared transparent cover according to claim 5 wherein the interface between the base layer and the dielectric multilayer film is convex.

7. The infrared transparent cover according to claim 1, wherein the cover is attached to an infrared signal port of an electronic device, and the cover includes an outer surface exposed outside the electronic device and an inner surface arranged inside the electronic device;
the base layer is colorless and transparent and includes a first surface close to the inner surface of the cover and a second surface close to the outer surface of the cover; and
the dielectric multilayer film is laminated on the first surface of the base layer; the cover further comprising:
a block layer laminated on the dielectric multilayer film, having infrared transparency, and inhibiting transmission of visible light; and
a diffusion layer laminated on the second surface of the base layer.

8. The infrared transparent cover according to claim 1, wherein:
the base layer is colorless and transparent and includes a first surface close to the inner surface of the cover and a second surface close to the outer surface of the cover; and
the dielectric multilayer film is laminated on the first surface of the base layer;
the cover further comprising:
an information printed layer laminated on the dielectric multilayer film;
a black layer laminated on the information printed layer, having infrared transparency, and inhibiting transmission of visible light; and
a diffusion layer laminated on the second surface of the base layer.

9. The infrared transparent cover according to claim 8, wherein the information printed layer is a monolayer.

10. The infrared transparent cover according to claim 1, wherein the base layer is colorless and transparent and includes a first surface close to the inner surface of the cover and a second surface close to the outer surface of the cover, the cover further comprising:
an information printed layer laminated between the first surface of the base layer and the dielectric multilayer film;
a black layer laminated on the dielectric multilayer film, having infrared transparency, and inhibiting transmission of visible light; and
a diffusion layer laminated on the second surface of the base layer.

11. The infrared transparent cover according to claim 8 or 10, wherein the information printed layer includes a plurality of layers.

12. The infrared transparent cover according to claim 1, wherein:
the base layer is clear and colorless and includes a first surface close to the inner surface of the cover and a second surface close to the outer surface of the cover; and
the dielectric multilayer film is formed on the second surface of the base layer;
the cover further comprising:
a black layer laminated on the first surface of the base layer, having infrared transparency, and inhibiting transmission of visible light; and
a protective layer laminated on the dielectric multilayer film.

13. An electronic device comprising:
a housing with an opening;
an infrared detection element accommodated in the housing; and
the infrared transparent cover according to any one of claims 1 to 12 attached to the housing and closing the opening.

14. A method for manufacturing an infrared transparent cover according to any one of claims 1 to 12 comprising the step of:
forming the dielectric multilayer film on one surface of the base layer under a low temperature by performing ion assist deposition, plasma CVD, or sputtering.

## Patentansprüche

1. Infrarottransparente Abdeckung (1) für einen Infrarotsignalport einer Elektronikeinrichtung, wobei die infrarottransparente Abdeckung Folgendes umfasst:
eine Basisschicht (2) mit Infrarottransparenz, **dadurch gekennzeichnet, dass** die äußere Oberfläche (3a) oder die innere Oberfläche (2a) der Basisschicht eine matte Oberfläche ist; und
ein infrarottransparenter und sichtbares Licht reflektierender dielektrischer Mehrschichtfilm (3), der auf die äußere Oberfläche (3a) oder die innere Oberfläche (2a) der Basisschicht laminiert ist, wobei der dielektrische Mehrschichtfilm (3) Licht mit einer auf die gewünschte Farbe eingestellten Farbe reflektiert, wobei die infrarottransparente Abdeckung eine Erscheinungseinfärbung mit einem perlenartigen Glanz aufweist.

2. Infrarottransparente Abdeckung nach Anspruch 1, die weiterhin Folgendes umfasst:
eine Primerschicht, die einem Hartbeschichtungsprozess unterzogen worden ist und zwischen dem dielektrischen Mehrschichtfilm und der Basisschicht laminiert ist, wobei der dielektrische Mehrschichtfilm als eine äußere Oberfläche der Abdeckung dient.

3. Infrarottransparente Abdeckung nach Anspruch 1, wobei die Basisschicht eine erste Oberfläche, auf die der dielektrische Mehrschichtfilm laminiert ist, und eine der ersten Oberfläche gegenüberliegende zweite Oberfläche enthält, wobei die Abdeckung weiterhin Folgendes umfasst:
einen Antireflexfilm, der auf die zweite Oberfläche der Basisschicht laminiert ist, wobei der dielektrische Mehrschichtfilm und der Antireflexfilm jeweils als eine innere Oberfläche und eine äußere Oberfläche der Abdeckung dienen.

4. Infrarottransparente Abdeckung nach Anspruch 1, wobei:
die Basisschicht zwei Oberflächen aufweist und
der dielektrische Mehrschichtfilm auf die beiden Oberflächen der Basisschicht laminiert ist.

5. Infrarottransparente Abdeckung nach Anspruch 1, wobei eine Grenzfläche zwischen der Basisschicht und dem dielektrischen Mehrschichtfilm gekrümmt ist.

6. Infrarottransparente Abdeckung nach Anspruch 5, wobei die Grenzfläche zwischen der Basisschicht und dem dielektrischen Mehrschichtfilm konvex ist.

7. Infrarottransparente Abdeckung nach Anspruch 1, wobei die Abdeckung an einem Infrarotsignalport einer Elektronikeinrichtung angebracht ist und die Abdeckung eine äußere Oberfläche, die außerhalb der Elektronikeinrichtung exponiert ist, und eine innerhalb der Elektronikeinrichtung angeordnete innere Oberfläche enthält;
die Basisschicht farblos und transparent ist und eine erste Oberfläche nahe der inneren Oberfläche der Abdeckung und eine zweite Oberfläche nahe der äußeren Oberfläche der Abdeckung enthält; und
der dielektrische Mehrschichtfilm auf die erste Oberfläche der Basisschicht laminiert ist;
wobei die Abdeckung weiterhin Folgendes umfasst:
eine schwarze Schicht, die auf den dielektrischen Mehrschichtfilm laminiert ist, mit Infrarottransparenz und die Durchlässigkeit von sichtbarem Licht blockierend; und
eine Diffusionsschicht, die auf die zweite Oberfläche der Basisschicht laminiert ist.

8. Infrarottransparente Abdeckung nach Anspruch 1, wobei:
die Basisschicht farblos und transparent ist und eine erste Oberfläche nahe der inneren Oberfläche der Abdeckung und eine zweite Oberfläche nahe der äußeren Oberfläche der Abdeckung enthält; und
der dielektrische Mehrschichtfilm auf die erste Oberfläche der Basisschicht laminiert ist;
wobei die Abdeckung weiterhin Folgendes umfasst:
eine mit Informationen bedruckte Schicht, die auf den dielektrischen Mehrschichtfilm laminiert ist;
eine schwarze Schicht, die auf die mit Informationen bedruckte Schicht laminiert ist, mit Infrarottransparenz un d die Durchlässigkeit von sichtbarem Licht blockierend; und
eine Diffusionsschicht, die auf die zweite Oberfläche der Basisschicht laminiert ist.

9. Infrarottransparente Abdeckung nach Anspruch 8, wobei die mit Informationen bedruckte Schicht eine Monoschicht ist.

10. Infrarottransparente Abdeckung nach Anspruch 1, wobei die Basisschicht farblos und transparent ist und eine erste Oberfläche nahe der inneren Oberfläche der Abdeckung enthält und eine zweite Oberfläche nahe der äußeren Oberfläche der Abdeckung, wobei die Abdeckung weiterhin Folgendes umfasst:
eine mit Informationen bedruckte Schicht, die zwischen die erste Oberfläche der Basisschicht und den dielektrischen Mehrschichtfilm laminiert ist;
eine schwarze Schicht, die auf den dielektrischen Mehrschichtfilm laminiert ist, mit Infrarottransparenz und die Durchlässigkeit von sichtbarem Licht blockierend; und
eine Diffusionsschicht, die auf die zweite Oberfläche der Basisschicht laminiert ist.

11. Infrarottransparente Abdeckung nach Anspruch 8 oder 10, wobei die mit Informationen bedruckte Schicht mehrere Schichten enthält.

12. Infrarottransparente Abdeckung nach Anspruch 1, wobei:
die Basisschicht durchsichtig und farblos ist und eine erste Oberfläche nahe der inneren Oberfläche der Abdeckung und eine zweite Oberfläche nahe der äußeren Oberfläche der Abdeckung enthält; und
der dielektrische Mehrschichtfilm auf der zweiten Oberfläche der Basisschicht ausgebildet ist;
wobei die Abdeckung weiterhin Folgendes umfasst:
eine schwarze Schicht, die auf die erste Oberfläche de r Basisschicht laminiert ist, mit Infrarottransparenz und die Durchlässigkeit von sichtbarem Licht blockierend; und
eine Schutzschicht, die auf den dielektrischen Mehrschichtfilm laminiert ist.

13. Elektronikeinrichtung, die Folgendes umfasst:
ein Gehäuse mit einer Öffnung;
ein Infrarotdetektionselement, das in dem Gehäuse untergebracht ist; und
die infrarottransparente Abdeckung nach einem der Ansprüche 1 bis 12, die an dem Gehäuse angebracht ist und die Öffnung schließt.

14. Verfahren zu m Herstellen einer infrarottransparenten Abdeckung nach einem der Ansprüche 1 bis 12, umfassend den folgenden Schritt:
Ausbilden des dielektrischen Mehrschichtfilms auf einer Oberfläche der Basisschicht unter einer niedrigen Temperatur durch Durchführen einer ionenunterstützten Abscheidung, Plasma-CVD oder Sputtern.

## Revendications

1. Couvercle transparent aux infrarouges (1) pour un port de signal infrarouge d'un dispositif électronique, le couvercle transparent aux infrarouges comprenant :
une couche de base (2) présentant une transparence aux infrarouges, **caractérisée en ce que** la surface externe (3a) ou la surface interne (2a) de la couche de base est une surface dépolie ; et
un film diélectrique multicouche transparent aux infrarouges et réfléchissant la lumière visible (3) laminé sur la surface externe (3a) ou la surface interne (2a) de la couche de base, le film diélectrique multicouche (3) réfléchissant la lumière ayant une couleur ajustée à la couleur souhaitée,
le couvercle transparent aux infrarouges ayant une coloration apparente avec un éclat semblable à une perle.

2. Couvercle transparent aux infrarouges selon la revendication 1, comprenant en outre :
une couche d'apprêt qui a subi un procédé de revêtement dur et est laminée entre le film diélectrique multicouche et la couche de base, le film diélectrique multicouche servant de surface externe du couvercle.

3. Couvercle transparent aux infrarouges selon la revendication 1, dans lequel la couche de base comprend une première surface sur laquelle est laminé le film diélectrique multicouche et une deuxième surface à l'opposé de la première surface, le couvercle comprenant en outre :
un film antireflet laminé sur la deuxième surface de la couche de base, le film diélectrique multicouche et le film antireflet servant respectivement de surface interne et de surface externe du couvercle.

4. Couvercle transparent aux infrarouges selon la revendication 1, dans lequel :
la couche de base comporte deux surfaces ; et
le film diélectrique multicouche est laminé sur les deux surfaces de la couche de base.

5. Couvercle transparent aux infrarouges selon la revendication 1, dans lequel l'interface entre la couche de base et le film diélectrique multicouche est incurvée.

6. Couvercle transparent aux infrarouges selon la revendication 5, dans lequel l'interface entre la couche de base et le film diélectrique multicouche est convexe.

7. Couvercle transparent aux infrarouges selon la revendication 1, dans lequel :
le couvercle est fixé à un port de signal infrarouge d'un dispositif électronique, et le couvercle comprend une surface externe exposée à l'extérieur du dispositif électronique et un e surface interne positionnée à l'intérieur du dispositif électronique ;
la couche de base est incolore et transparente et comprend une première surface proche de la surface interne du couvercle et une deuxième surface proche de la surface externe du couvercle ; et
le film diélectrique multicouche est laminé sur la première surface de la couche de base ;
le couvercle comprenant en outre :
une couche de blocage laminée sur le film diélectrique multicouche, présentant une transparence aux infrarouges, et empêchant la transmission de la lumière Visible ; et
une couche de diffusion laminée sur la deuxième surface de la couche de base.

8. Couvercle transparent aux infrarouges selon la revendication 1, dans lequel :
la couche de base est incolore et transparente et comprend une première surface proche de la surface interne du couvercle et une deuxième surface proche de la surface externe du couvercle ; et
le film diélectrique multicouche est laminé sur la première surface de la couche de base ;
le couvercle comprenant en outre :
une couche imprimée d'informations laminée sur le film diélectrique multicouche ;
une couche noire laminée sur la couche imprimée d'informations présentant une transparence aux infrarouges et empêchant la transmission de la lumière visible ; et
une couche de diffusion laminée sur la deuxième surface de la couche de base.

9. Couvercle transparent aux infrarouges selon la revendication 8, da n s lequel la couc h e imprimée d'informations est une monocouche.

10. Couvercle transparent aux infrarouges selon la revendication 1, dans lequel la couche de base est incolore et transparente et comprend une première surface proche de la surface interne du couvercle et une deuxième surface proche de la surface externe du couvercle, le couvercle comprenant en outre :
une couche imprimée d'informations laminée entre la première surface de la couche de base et le film diélectrique multicouche ;
une couche noire laminée sur le film diélectrique multicouche présentant une transparence aux infrarouges et empêchant la transmission de la lumière visible ; et
une couche de diffusion laminée sur la deuxième surface de la couche de base.

11. Couvercle transparent aux infrarouges selon la revendication 8 ou 10, dans lequel la couche imprimée d'informations comprend une pluralité de couches.

12. Couvercle transparent aux infrarouges selon la revendication 1, dans lequel :
la couche de base est transparente et incolore et comprend une première surface proche de la surface interne du couvercle et une deuxième surface proche de la surface externe du couvercle ; et
le film diélectrique multicouche est formé sur la deuxième surface de la couche de base ;
le couvercle comprenant en outre
une couche noire laminée sur la première surface de la couche de base, présentant une transparence aux infrarouges, et empêchant la transmission de la lumière visible ; et
une couche protectrice laminée sur le film diélectrique multicouche.

13. Dispositif électronique comprenant :
un boîtier avec une ouverture ;
un élément de détection d'infrarouges logé dans le boîtier ; et
le couvercle transparent aux infrarouges selon l'une quelconque des revendications 1 à 12 fixé au boîtier et fermant l'ouverture.

14. Procédé de fabrication d'un couvercle transparent aux infrarouges selon l'une quelconque des revendications 1 à 12 comprenant l'étape consistant à :
former le film diélectrique multicouche sur une surface de la couche de base à basse température en effectuant un dépôt assisté par faisceau d'ions, un dépôt par CVD assisté par plasma, ou une pulvérisation cathodique.
